# FASCICULE DE BREVET EUROPEEN

(11) **EP 3 384 535 B1**
(45) Date de publication et mention de la délivrance du brevet: **18.09.2019**
(21) Numéro de dépôt: 16819598.0
(22) Date de dépôt: 02.12.2016
(51) Int. Cl.: H01L 31/078

(54) **CELLULE PHOTOVOLTAÏQUE**
FOTOVOLTAISCHE ZELLE
PHOTOVOLTAIC CELL

(30) Priorité: 04.12.2015 FR 1561893
(43) Date de publication de la demande: 10.10.2018
(73) Titulaire: Centre National de la Recherche Scientifique (CNRS), 75016 Paris (FR); École Supérieure d'Électricité, 91190 Gif sur Yvette (FR); Université de Versailles Saint-Quentin-en-Yvelines, 78000 Versailles (FR)
(72) Inventeur: DJEBBOUR, Zakaria, 91140 Villebon sur Yvette (FR); MIGAN, Anne, 91120 Palaiseau (FR); KLEIDER, Jean-Paul, 91440 Bures sur Yvette (FR); EL-HUNI, Walid, 78114 Magny les Hameaux (FR)
(74) Mandataire: Lavoix
(86) Numéro de dépôt international: PCT/FR2016/053195
(87) Numéro de publication internationale: WO 2017/093695

(56) Documents cités:
- WO-A1-2015/151422
- US-A- 4 295 002
- US-A1- 2010 083 997
- US-A1- 2014 209 149

## Description

La présente invention est relative aux cellules photovoltaïques.

Plus particulièrement, l'invention se rapporte à une cellule photovoltaïque multi jonctions p-n.

Il existe deux types principaux de cellules multi jonctions: les cellules à deux électrodes, l'une en face avant et l'autre en face arrière, et les cellules à trois ou quatre électrodes :
- Le premier type, utilise un empilement de plusieurs sous-cellules à jonction pn et est désigné couramment par le terme monolithique.
- Le deuxième type utilise des sous-cellules fonctionnant indépendamment l'une de l'autre, les électrodes de contact propres à chacune des sous-cellules étant formées sur ses faces supérieure et inférieure. Dans les cellules monolithiques seules la première et la dernière sous-cellule sont munies d'électrodes, la première sur sa face avant et la dernière sur sa face arrière. Ceci nécessite un ajustement minutieux des épaisseurs des différentes couches constituantes car le même courant doit circuler à travers chacune des sous-cellules. Par ailleurs, il est indispensable dans ce type de structure de réaliser des jonctions tunnel entre les sous-cellules, afin de permettre le passage du courant d'une sous-cellule à la suivante.
Le document " Towards highly efficient 4-terminal mechanical photovoltaic stacks" (G. Flamand et al., III-Vs review 19 (2006) 24) décrit un exemple d'une cellule photovoltaïque multi jonctions p-n, à deux jonctions p-n, séparées par une couche d'isolation, chaque jonction p-n fonctionnant indépendamment, les électrodes de contact propres à chacune des jonctions étant formées sur ses faces supérieure et inférieure. La réalisation de telles électrodes nécessite des procédés de gravure souvent complexes pour accéder à l'interface entre la jonction p-n et la couche d'isolation pour former l'électrode enterrée entre la jonction p-n et la couche d'isolation, en face inférieure de la jonction du haut et en face supérieure de la jonction du bas. De plus, les électrodes de contact sous forme de grilles qui permettent d'assurer une collecte efficace des porteurs photo-générés, doivent être parfaitement alignées, pour ne pas augmenter notamment l'ombrage par les parties métalliques des grilles sur la jonction du bas.

La présente invention a notamment pour but de pallier ces inconvénients.

On connait notamment des jonctions p-n à contacts inter-digités tel que décrit dans le document « *Design, fabrication and characterisation of a* 24.4% *efficient interdigitated back contact solar cell* » de Franklin et. al.

Les documents WO2015151422, US2010083997, US2014209149 et US4295002 divulguent différentes configurations connues de cellules solaires multi-jonctions.

L'invention propose une architecture de cellule photovoltaïque multi jonctions p-n à électrode de contact commune aux jonctions.

A cet effet, selon l'invention, une cellule photovoltaïque du genre en question comprend au moins **une première couche d'un premier matériau absorbeur** comprenant une face avant, ainsi qu'une face arrière sur laquelle des premières électrodes de contact ont une première polarité et sont inter-digitées avec des deuxièmes électrodes de contact ayant une seconde polarité, opposée à ladite première polarité, **caractérisée en ce que** la cellule comporte en outre **une deuxième couche d'un deuxième matériau absorbeur,** au-dessus de la face avant de la première couche, et comprenant une face avant et une face arrière, des troisièmes électrodes de contact ayant ladite seconde polarité étant placées sur la face avant de la deuxième couche, et en ce que les premier et deuxième matériaux semi-conducteurs, possèdent des affinités électroniques respectives, d'une part, et des largeurs de bande interdite respectives, d'autre part, choisies de sorte que des porteurs ayant la première polarité, sont capables de transiter via une interface entre la première et la deuxième couche et sont collectés depuis l'ensemble des première et deuxième couches par les premières électrodes, et des porteurs ayant la deuxième polarité sont collectés depuis la première couche par les deuxièmes électrodes, et des porteurs ayant la deuxième polarité sont collectés depuis la deuxième couche par les troisièmes électrodes.

Grâce à ces dispositions, les différentes électrodes de contact de la cellule photovoltaïque sont disponibles sans nécessité de graver et sans étape d'alignement de grilles de contact enterrées. Ces cellules photovoltaïques, également à très hauts rendements, sont beaucoup moins chères à la fabrication.

Dans des modes de réalisation préférés de l'invention, on peut éventuellement avoir recours en outre à l'une et/ou à l'autre des dispositions suivantes :
- des porteurs ayant la deuxième polarité sont collectés depuis la deuxième couche par les troisièmes électrodes, sans possibilité de franchir ladite interface entre la première et la deuxième couche ;
- le premier matériau absorbeur comporte un dopage selon la première polarité ;
- la deuxième couche comporte en sa face avant une couche de contact portant les troisièmes électrodes et comportant un dopage selon la deuxième polarité ;
- elle comporte en outre **une couche intermédiaire** entre la première couche et la deuxième couche, réalisée dans un troisième matériau semi-conducteur telle que la couche intermédiaire bloque les porteurs de deuxième polarité photo-générés dans la deuxième couche pour être collectés uniquement par les troisièmes électrodes, et laisse passer les porteurs de première polarité photo-générés dans la deuxième couche pour être collectés par les premières électrodes ;
- l'interface entre les première et deuxième couches comporte une couche d'adaptation d'accord de maille entre les premier et deuxième matériaux ;
- l'un au moins des matériaux semi-conducteur est un empilement d'alliages semi-conducteur ;
- la première couche de matériau absorbeur est en Silicium (Si) ;
- la deuxième couche de matériau absorbeur comprend un alliage de gallium indium phosphure (GaInP) ;
- la couche intermédiaire comprend l'un parmi du nitrure de gallium (GaN), de l'oxyde de zinc (ZnO), de l'oxyde de Nickel (NiO) ou de l'oxyde de Manganèse (MnO) ;
- la deuxième couche de matériau absorbeur est à base de chalcopyrites (CIGS) empilées avec des sulfures de cadmium (CdS) et/ou des sulfures et oxydes de Zinc (ZnOS) ;
- la deuxième couche de matériau absorbeur (2) est dans un matériau à base de kestérites (CZTS) empilées avec des sulfures de cadmium (CdS) et/ou des sulfures et oxydes de Zinc (ZnOS) ;
- la couche intermédiaire est une couche d'oxyde de zinc (ZnO) ;
- la deuxième couche de matériau absorbeur est dans un matériau à base de pérovskites empilées sur du dioxyde titane (Ti02) et dans laquelle la couche intermédiaire est du dioxyde d'étain dopé fluor (FTO) ;
- la deuxième couche de matériau absorbeur (2) est à base de silicium amorphe ou de silicium microcristallin hydrogéné, ou d'un alliage amorphe ou microcristallin de silicium, carbone et oxygène ;
- une surface est dotée d'un revêtement anti-reflet.

D'autres caractéristiques et avantages de l'invention apparaîtront au cours de la description suivante d'une de ses formes de réalisation, donnée à titre d'exemple non limitatif, en regard des dessins joints.

Sur les dessins :
- les figures 1 a, b, c, illustrent la structure, le diagramme des bandes d'énergie, et le schéma électrique équivalent d'une cellule photovoltaïque multi jonctions p-n pour laquelle la première couche est dopée n ;
- les figures 2 a, b, c, illustrent la structure, le diagramme des bandes d'énergie, et le schéma électrique équivalent d'une cellule photovoltaïque multi jonctions p-n pour laquelle la première couche est dopée p ;
- les figures 3 a, b illustrent le cas d'une cellule photovoltaïque multi-jonction avec une couche intermédiaire ;
- les figures 4 a, b illustrent le cas d'une cellule photovoltaïque multi-jonction lorsque le deuxième matériau absorbeur est une couche à base d'empilements d'alliages III-V ;
- les figures 5 a, b illustrent le cas d'une cellule photovoltaïque multi-jonction lorsqu'une couche de nitrure de gallium intrinsèque sert de couche intermédiaire 3 ;
- la figure 6 illustre le cas d'une cellule photovoltaïque multi-jonction lorsque la deuxième couche de matériau absorbeur est une couche d'alliage de phosphure de gallium et d'indium ;
- la figure 7 illustre le cas d'une cellule photovoltaïque multi-jonction lorsque la deuxième couche de matériau absorbeur est un empilement d'une couche de sulfure de cadmium ou de sulfure et oxyde de zinc avec une couche de matériau à base de chalcopyrites ou de kestérites ;
- la figure 8 illustre le cas d'une cellule photovoltaïque multi-jonction lorsque la deuxième couche de matériau absorbeur 2 est à base de pérovskites empilées sur du dioxyde de titane;
- la figure 9 illustre la densité de courant extraite aux électrodes en fonction de la tension générée aux bornes des électrodes.

Sur les différentes figures, les mêmes références désignent des éléments identiques ou similaires.

Dans le contexte de l'invention, on entend par polarité le type n ou le type p. On considère la polarité de l'électrode, du porteur et du dopage. La première polarité désigne donc soit le type n soit le type p, et la deuxième polarité désigne l'autre type. **Des porteurs de type n sont des électrons et des porteurs de type p sont des trous.**

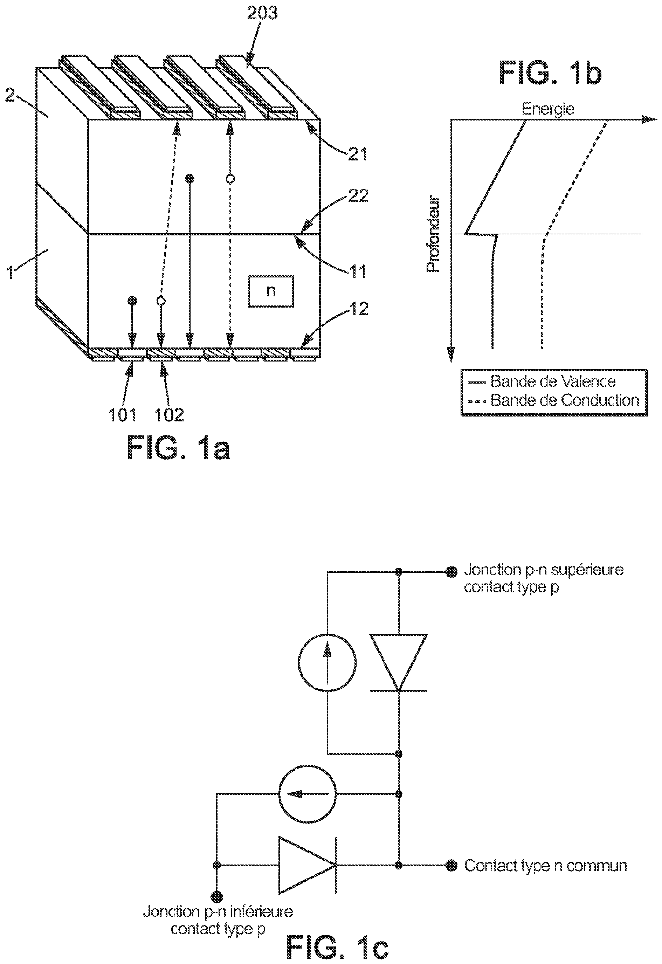

La **figure 1a** représente une cellule photovoltaïque multi jonctions p-n comprenant :
- **une première couche d'un premier matériau absorbeur** 1 de première polarité comprenant une face avant 11, ainsi qu'une face arrière 12 sur laquelle des premières électrodes de contact 101 de première polarité sont inter-digitées avec des deuxièmes électrodes de contact 102 ayant une seconde polarité, opposée à ladite première polarité,
- **une deuxième couche d'un deuxième matériau absorbeur** 2, au-dessus de la face avant de la première couche 1, et comprenant une face avant 21 et une face arrière 22, des troisièmes électrodes de contact 203 ayant ladite seconde polarité étant placées sur la face avant 21 de la deuxième couche 2.

Une première électrode de contact 101 de première polarité est obtenue par le dépôt d'un métal sur du matériau fortement dopé de première polarité. Une deuxième ou une troisième électrode de contact de deuxième polarité est obtenue par le dépôt d'un métal sur du matériau fortement dopé de deuxième polarité.
Une telle architecture permet de convertir différentes parties du spectre solaire, une partie par matériau absorbeur, pour obtenir de meilleurs rendements.
La **figure 1a** illustre en particulier le cas où la première polarité est la polarité de type n, et la deuxième polarité est la polarité de type p. Dans ce cas les premières électrodes de contact 101 ont une polarité de type n, les deuxièmes électrodes de contact 102 ont une polarité de type p et les troisièmes électrodes de contact 203 ont une polarité de type p.
La **figure 1b** donne le diagramme des bandes d'énergie à l'équilibre thermodynamique de chaque couche dans ce cas, c'est-à-dire les seuils des bandes de valence et de conduction dans chaque couche et à l'interface entre les couches, en fonction de l'épaisseur à laquelle on regarde dans la cellule. Les premier et deuxième matériaux absorbeurs, semi-conducteurs, possèdent des affinités électroniques respectives, d'une part, et des largeurs de bande interdite respectives (distance en énergie entre le haut de la bande de valence et le bas de la bande de conduction), d'autre part, choisies de sorte :
- qu'il n'y ait quasiment pas de discontinuité entre les bandes de conduction entre le premier et le deuxième matériau absorbeur,
- et, que les bandes interdites des deux absorbeurs soient choisies de sorte que la cellule tandem ait le meilleur rendement.

La différence entre les bandes interdites des matériaux crée une discontinuité entre les bandes de valences des premier et deuxième absorbeurs telle qu'à l'interface entre le premier et le deuxième absorbeur, l'énergie de la bande de valence du premier matériau absorbeur est notamment strictement supérieure à l'énergie de la bande de valence du deuxième matériau absorbeur.
Ainsi :
- Des porteurs de type n (électrons), sont capables de transiter via une interface de la deuxième vers la première couche et sont collectés depuis l'ensemble des première et deuxième couches par les premières électrodes 101, et
- Des porteurs de type p (trous) sont collectés depuis la première couche 1 par les deuxièmes électrodes 102,
- Des porteurs de type p (trous) sont collectés depuis la deuxième couche 2 par les troisièmes électrodes 203.
En variante, lorsque la discontinuité est très importante, par exemple supérieure à 0,350 eV entre les bandes de valence, les porteurs de polarité p sont collectés depuis la deuxième couche 2 par les troisièmes électrodes 203, sans possibilité de franchir ladite interface de la deuxième vers la première couche.
Dans un mode privilégié de réalisation, le premier matériau absorbeur 1 est préférentiellement dopé, alors de type n. En particulier le premier matériau absorbeur 1 peut être du silicium (Si). La deuxième couche de matériau absorbeur 2 est par exemple un empilement d'alliages semi-conducteurs pouvant être dopés p ou non dopés. Le deuxième absorbeur 2 peut être un empilement de couches dopées et non dopées. Chaque jonction p-n peut être schématisée par une diode dont le côté p constitue l'anode et le côté n la cathode. Le fonctionnement de la cellule dans le cas d'une telle polarité peut donc être schématisé par l'association de deux diodes, chaque diode étant en parallèle avec un générateur de courant, comme illustré à la **figure 1c****.**

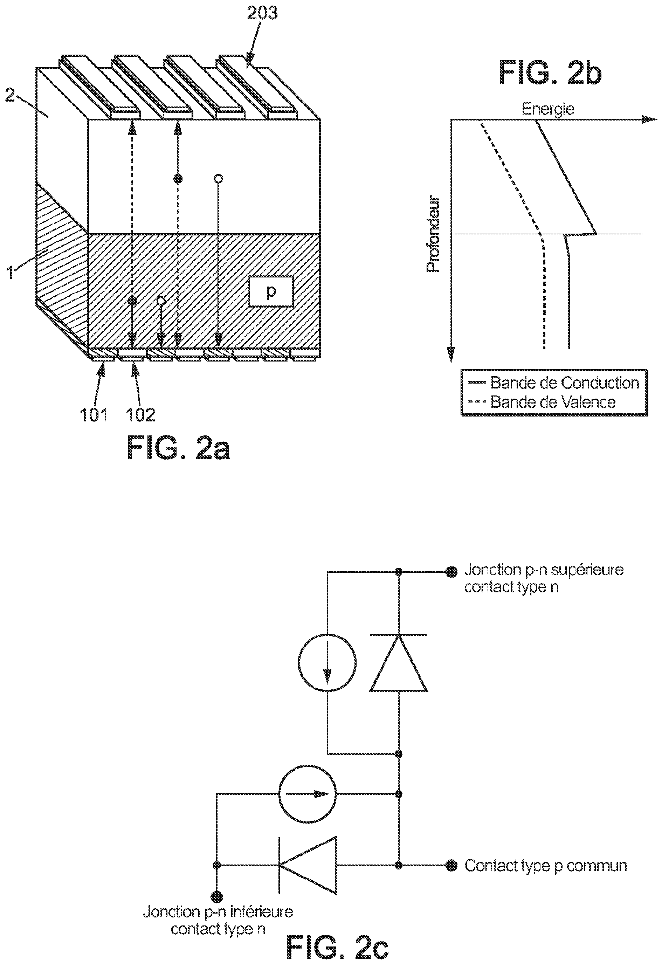

La **figure 2a** illustre le cas de polarité inverse c'est-à-dire le cas où la première polarité est la polarité de type p, et la deuxième polarité est la polarité de type n. Dans ce cas les premières électrodes de contact 101 ont une polarité de type p, les deuxièmes électrodes de contact 102 ont une polarité de type n et les troisièmes électrodes de contact 203 ont une polarité de type n. La **figure 2b** donne le diagramme des bandes d'énergie à l'équilibre thermodynamique de chaque couche dans ce cas. Les premier et deuxième matériaux absorbeurs, semi-conducteurs, possèdent des affinités électroniques respectives, d'une part, et des largeurs de bande interdite respectives, d'autre part, choisies de sorte :
- qu'il n'y ait quasiment pas de discontinuité entre les bandes de valence entre le premier et le deuxième matériau absorbeur,
- et, que les bandes interdites des deux absorbeurs soient choisies de sorte que la cellule tandem ait le meilleur rendement.

La différence entre les bandes interdites des matériaux crée une discontinuité entre les bandes de conduction des premier et deuxième absorbeurs telle qu'à l'interface entre le premier et le deuxième absorbeur, l'énergie de la bande de conduction du premier matériau absorbeur est notamment strictement inférieure à l'énergie de la bande de conduction du deuxième matériau absorbeur. Ainsi :
- Des porteurs de type p (trous), sont capables de transiter via l'interface de la deuxième vers la première couche et sont collectés depuis l'ensemble des première et deuxième couches par les premières électrodes 101, et
- Des porteurs de type n (électrons) sont collectés depuis la première couche 1 par les deuxièmes électrodes 102,
- Des porteurs de type n (électrons) sont collectés depuis la deuxième couche 2 par les troisièmes électrodes 203.
En variante, lorsque la discontinuité est très importante, par exemple supérieure à 0,350 eV entre les bandes de conduction, les porteurs de polarité n sont collectés depuis la deuxième couche 2 par les troisièmes électrodes 203, sans possibilité de franchir ladite interface de la deuxième vers la première couche. Dans un mode privilégié de réalisation, le premier matériau absorbeur 1 est préférentiellement dopé, alors de type p. En particulier le premier matériau absorbeur 1 peut être du silicium (Si). Le deuxième absorbeur 2 est un empilement d'alliages semi-conducteurs pouvant être dopés n ou non dopés. Le deuxième absorbeur 2 peut être un empilement de couches dopées et non dopées.
Le fonctionnement de la cellule dans le cas d'une telle polarité peut également être schématisé par l'association de deux diodes, chaque diode étant en parallèle avec un générateur de courant, comme illustré à la figure 2c.

Dans le cas particulier où la première couche de matériau absorbeur 1 a une largeur de bande interdite de 1.12eV par exemple dans le cas du silicium, la deuxième couche de matériau absorbeur 2 est par exemple semiconductrice avec préférentiellement une largeur de bande interdite entre 1.7 et 1.8eV.

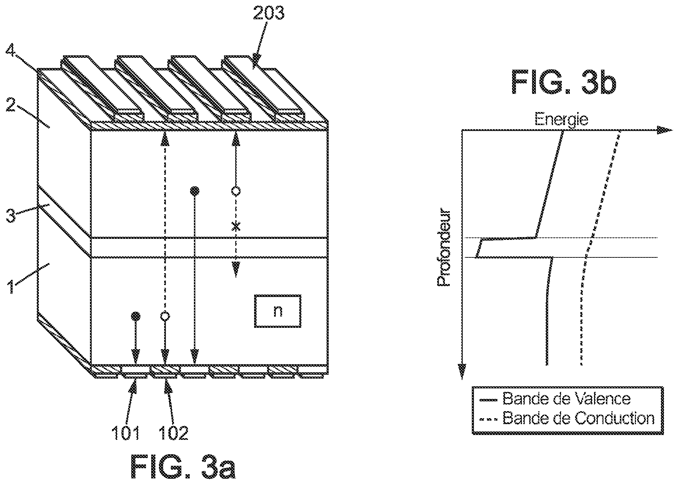

Comme illustré à la **figure 3a****,** la deuxième couche 2 peut comporter en sa face avant une couche fenêtre de contact (large bande interdite) 4 portant les troisièmes électrodes 203 et comportant un dopage selon la polarité p dans le cas où la première polarité est la polarité de type n et la deuxième polarité est la polarité de type p. La couche fenêtre de contact 4 est par exemple en empilement d'alliages semi-conducteurs dopés p.

La **figure 3a** illustre également le cas où la cellule photovoltaïque comprend en outre une couche intermédiaire 3 entre la première couche 1 et la deuxième couche 2, réalisée dans un troisième matériau semi-conducteur dans le cas où la première polarité est la polarité de type n et la deuxième polarité est la polarité de type p. Comme illustré énergétiquement à la figure 3b, la couche intermédiaire 3 crée une distance en énergie entre les hauts des bandes de valence des deux couches de matériau absorbeur sélectionnant ainsi les flux de porteurs possibles. Ainsi la couche intermédiaire 3 bloque les porteurs de polarité p photo-générés dans la deuxième couche 2 pour être collectés uniquement par les troisièmes électrodes 203, et laisse passer les porteurs de polarité n photo-générés dans la deuxième couche 2 pour être collectés par les premières électrodes 101. La couche intermédiaire 3 est par exemple un semi-conducteur ou un empilement d'alliages semiconducteurs.

L'interface entre les première et deuxième couches peut comporter une couche d'adaptation 40 d'accord de maille entre les premier et deuxième matériaux.

Les empilements semi-conducteurs peuvent s'obtenir soit par croissance directe sur la face supérieure de la couche sur laquelle ils sont déposés soit par croissance sur un substrat approprié suivie d'un décollage chimique ou laser et d'un collage sur la face supérieure de la couche.

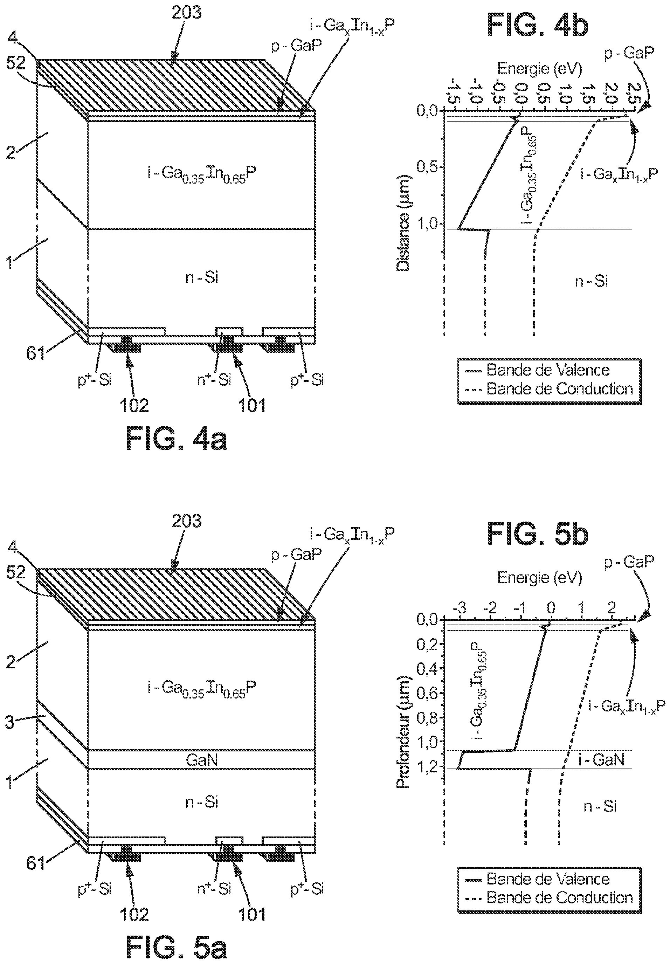

**Dans un premier exemple de réalisation** de l'invention, illustré à la **figure 4a****,** le premier matériau absorbeur est du silicium dopé n, et le deuxième matériau absorbeur est une couche à base d'empilements d'alliages III-V, par exemple un alliage de phosphure d'indium et de gallium GaInP. Le premier matériau absorbeur a par exemple une épaisseur de 250pm et une densité de dopage de 2^{∗}10¹⁵cm⁻³. Le deuxième matériau absorbeur est par exemple du Ga_{0.35}In_{0.65}P intrinsèque. La couche de Ga_{0.35}In_{0.65}P a par exemple une épaisseur de 1µm, et une densité de dopage de 10¹⁴cm⁻³. La couche de Ga_{0.35}In_{0.65}P peut éventuellement être recouverte d'une couche d'adaptation 52 de GaₓIn₁₋ₓP d'épaisseur 50nm et de densité de dopage de 10¹⁴cm⁻³. La couche GaₓIn₁₋ₓP peut par exemple être une couche à bande interdite graduelle. L'intérêt d'une telle couche est d'assurer une continuité des bandes comme illustré à la figure 4b qui donne l'énergie des bandes de valence et de conduction de la cellule en fonction de la profondeur. Dans le cas où une couche fenêtre de contact 4 est portée par la face avant de la deuxième couche, celle-ci peut être une couche de phosphure de Gallium GaP dopée p, par exemple d'épaisseur 20nm et de densité de dopage 2^{∗}10¹⁸cm⁻³. Les premières électrodes de contact 101 ont par exemple chacune une largeur de 25pm sur toute la profondeur du matériau et sont par exemple séparées des deuxièmes électrodes de contact 102 par 50pm. Elles sont par exemple formées par un dopage local du silicium. Les deuxièmes électrodes de contact 102 ont par exemple chacune une largeur de 75pm sur toute la profondeur du matériau et une épaisseur de 150nm. Un revêtement anti-reflet peut être déposé à la surface de la cellule pour en augmenter le rendement. Une couche réflectrice 61 est par exemple placée entre les premières et deuxièmes électrodes, et le silicium localement dopé (n⁺ et p⁺).
Comme illustré à la **figure 4b****,** les affinités électroniques respectives, d'une part, et les largeurs de bande interdite respectives, d'autre part, sont telles qu'il n'y a quasiment pas de discontinuité entre les bandes de conduction entre le premier et le deuxième matériau absorbeur, et qu'il y a une discontinuité entre les bandes de valence telle qu'à l'interface entre le premier et le deuxième absorbeur, l'énergie de la bande de valence du premier matériau absorbeur est strictement supérieure à l'énergie de la bande de valence du deuxième matériau absorbeur.
Ainsi des porteurs de type n sont capables de transiter via l'interface de la deuxième à la première couche et sont collectés depuis l'ensemble des première et deuxième couches par les premières électrodes 101, et des porteurs de type p seront collectés depuis la première couche 1 par les premières électrodes 101, et des porteurs de type p sont collectés depuis la deuxième couche 2 par les troisièmes électrodes 203 et depuis la première couche 1 par les deuxièmes électrodes 102.

La **figure 5a** illustre le cas de la même cellule photovoltaïque que celle illustrée à la figure 4 mais dans le cas où une couche de nitrure de gallium GaN intrinsèque sert de couche intermédiaire 3 entre la première couche de matériau absorbeur 1 et la deuxième couche de matériau absorbeur 2. Dans ce cas comme illustré par le diagramme des bandes d'énergie à l'équilibre thermodynamique de la **figure 5b****,** la couche de nitrure de gallium GaN présente une discontinuité de bande de conduction quasi-nulle avec le silicium Si mais une discontinuité de bande de valence d'environ 2.3eV avec celui-ci. La couche de nitrure de gallium GaN a par exemple une épaisseur de 150nm. Des porteurs de type n sont capables de transiter via une interface de la deuxième vers la première couche et sont collectés depuis l'ensemble des première et deuxième couches par les premières électrodes 101, des porteurs de type p seront collectés depuis la première couche 1 par les deuxièmes électrodes 102, des porteurs de type p sont collectés depuis la deuxième couche 2 par les troisièmes électrodes 203, sans possibilité de franchir ladite interface entre la première et la deuxième couche. En particulier la couche intermédiaire 3 bloque les porteurs de polarité p photo-générés dans la deuxième couche 2 afin qu'ils soient collectés uniquement par les troisièmes électrodes 203, sans possibilité d'être collectés par les deuxièmes électrodes 102.

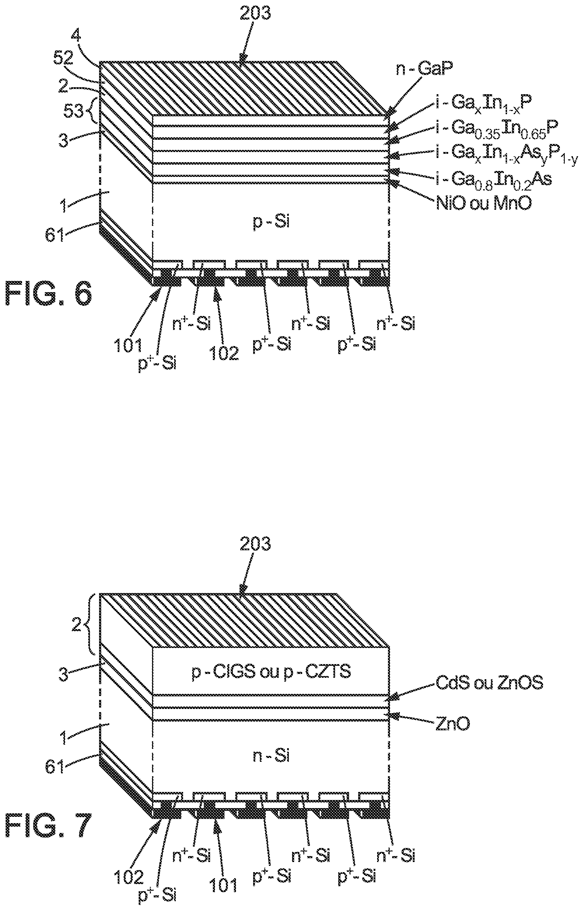

**Dans un deuxième exemple de réalisation,** illustré à la **figure 6****,** la première couche de matériau absorbeur est une couche de silicium dopé p, et la deuxième couche de matériau absorbeur est une couche d'alliage de phosphure de gallium et d'indium Ga_{0.35}In_{0.65}P (ou un empilement de telles couches). Un empilement de couches d'arséniure de gallium et d'indium Ga_{0.8}In_{0.2}As et de phosphure et d'arséniure de gallium et d'indium GaₓIn₁₋ₓAs_{y}P_{1-y} intrinsèques forment une couche d'adaptation 53 en face arrière. Une couche d'alliage de gallium indium phosphure GaₓIn₁₋ₓP intrinsèque forme une autre couche d'adaptation 52. La couche intermédiaire 3 est une couche d'oxyde de nickel NiO ou d'oxyde de manganese MnO. La couche fenêtre de contact 4 est une couche de phosphure de gallium GaP dopée n.

**Dans un troisième exemple de réalisation,** illustré à la **figure 7****,** la première couche de matériau absorbeur est une couche de silicium dopé n, et la deuxième couche de matériau absorbeur est un empilement d'une couche de sulfure de cadmium CdS ou de sulfure et oxyde de zinc ZnOS avec une couche de matériau à base de chalcopyrites Cu(In,Ga)(Se,S)₂ (CIGS) ou de kestérites Cu₂ZnSn (Se,S)₄ (CZTS), par exemple dopée p. La couche intermédiaire 3 est une couche d'oxyde de zinc (ZnO), par exemple de 200nm d'épaisseur, et avec une affinité électronique et une largeur de bande interdite adaptées aux deux absorbeurs. Les performances photovoltaïques sont alors quasi les mêmes.

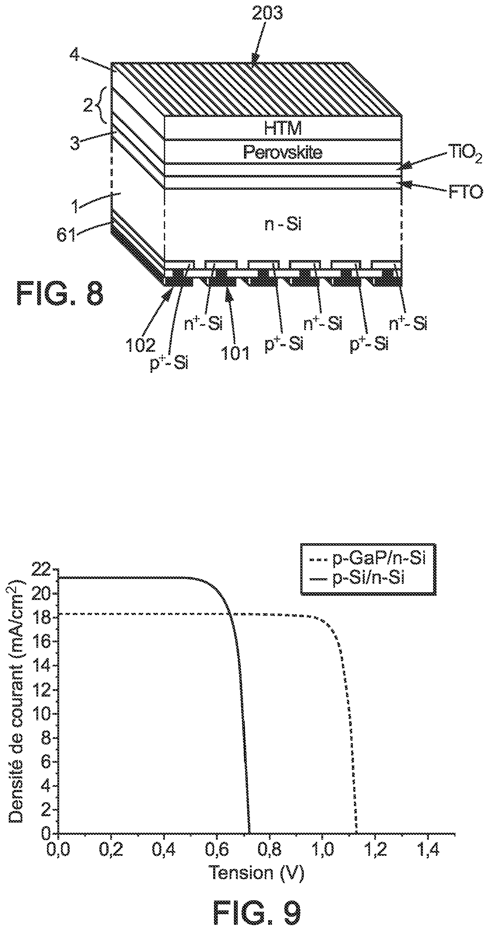

**Dans un quatrième exemple de réalisation,** illustré à la **figure 8****,** la première couche de matériau absorbeur est une couche de silicium dopé n et la deuxième couche de matériau absorbeur 2 est à base de pérovskites empilées sur du dioxyde de titane Ti02. La couche intermédiaire 3 est dans un matériau à base de dioxyde d'étain dopé fluor FTO. La couche fenêtre de contact 4 est une couche de matériau assurant le transport de trous (HTM).
En variante l'une au moins des couches de semi-conducteur peut être amorphe ou microcristalline en couche mince. En particulier il peut s'agir de semi-conducteurs, amorphes en couches minces, à base de silicium amorphe hydrogéné ou d'alliages amorphes hydrogénés choisis parmi le silicium, le carbone, et/ou l'oxygène. L'utilisation de tels semi-conducteurs permet une réalisation facilitée par des procédés de dépôt du type PECVD « basse température » (typiquement < 250°C), et donc bas coût (comparé à des procédés haute température).
Un des avantages de l'utilisation de ces matériaux est la possibilité de réaliser des semi-conducteurs avec une différence d'énergie entre la bande de valence et la bande de conduction nettement supérieure à la différence obtenue pour le silicium cristallin, d'où l'intérêt d'un tel matériau pour la jonction supérieure notamment.
Un dépôt adapté de couches amorphes ou microcristallines pourrait être réalisé directement à basse température sur du silicium cristallin. En effet il est reconnu que le silicium amorphe hydrogéné permet d'obtenir une excellente passivation de la surface du silicium cristallin et que le procédé de dépôt à basse température permet de ne pas dégrader les propriétés électroniques du silicium cristallin, contrairement à des techniques d'épitaxie à haute température.
Il pourra par exemple s'agir d'une structure avec une jonction supérieure en silicium hydrogéné amorphe ou d'un alliage amorphe de carbure de silicium hydrogéné ou d'oxyde de silicium amorphe hydrogéné, déposée sur la surface d'une jonction en silicium cristallin à contacts à l'arrière.

La **figure 9** illustre :
- la densité de courant extraite de l'électrode 203 en fonction de la tension générée aux bornes des électrodes 203 et 101, (courbe p-GaP/n-Si),
- la densité de courant extraite de l'électrode 102 en fonction de la tension générée aux bornes des électrodes 102 et 101, (courbe p-Si/n-Si),
   dans le cas d'une cellule photovoltaïque telle que décrite dans la demande dont la surface a été recouverte d'une couche de revêtement anti-reflet (courbe p-GaP/n-Si), et dans le cas d'une cellule photovoltaïque silicium classique (p-Si/n-Si). La couche anti-reflet est par exemple une couche de polymethylmethacrylate PPMA.
Le rendement obtenu est par exemple de l'ordre de 27.20% en l'absence de couche intermédiaire 3 et de l'ordre de 31.68% dans le cas avec une couche intermédiaire 3.

## Revendications

1. Cellule photovoltaïque multi-jonctions p-n à électrode de contact commune comprenant au moins **une première couche d'un premier matériau absorbeur** (1) comprenant une face avant (11), ainsi qu'une face arrière (12) sur laquelle des premières électrodes de contact (101) ont une première polarité et sont inter-digitées avec des deuxièmes électrodes de contact (102) ayant une seconde polarité, opposée à ladite première polarité,
**caractérisée en ce que** la cellule comporte en outre :
**une deuxième couche d'un deuxième matériau absorbeur** (2), au-dessus de la face avant de la première couche (1), et comprenant une face avant (21) et une face arrière (22), des troisièmes électrodes de contact (203) ayant ladite seconde polarité étant placées sur la face avant (21) de la deuxième couche (2),
**et en ce que** les premier et deuxième matériaux semi-conducteurs, possèdent des affinités électroniques respectives, d'une part, et des largeurs de bande interdite respectives, d'autre part, choisies de sorte que :
- Des porteurs ayant la première polarité, sont capables de transiter via une interface entre la première et la deuxième couche et sont collectés depuis l'ensemble des première et deuxième couches par les premières électrodes (101), et
- Des porteurs ayant la deuxième polarité sont collectés depuis la première couche (1) par les deuxièmes électrodes (102),
- Des porteurs ayant la deuxième polarité sont collectés depuis la deuxième couche (2) par les troisièmes électrodes (203).

2. Cellule photovoltaïque selon la revendication précédente, **caractérisée en ce que** des porteurs ayant la deuxième polarité sont collectés depuis la deuxième couche (2) par les troisièmes électrodes (203), sans possibilité de franchir ladite interface entre la première et la deuxième couche.

3. Cellule photovoltaïque selon l'une des revendications précédentes, **caractérisée en ce que** le premier matériau absorbeur comporte un dopage selon la première polarité.

4. Cellule photovoltaïque selon l'une des revendications précédentes, **caractérisé en ce que** la deuxième couche (2) comporte en sa face avant une couche de contact (4) portant les troisièmes électrodes (203) et comportant un dopage selon la deuxième polarité.

5. Cellule photovoltaïque selon l'une des revendications précédentes, **caractérisée en ce qu'**elle comporte en outre :
**une couche intermédiaire** (3) entre la première couche (1) et la deuxième couche (2), réalisée dans un troisième matériau semi-conducteur telle que la couche intermédiaire (3) bloque les porteurs de deuxième polarité photo-générés dans la deuxième couche (2) pour être collectés uniquement par les troisièmes électrodes (203),
et laisse passer les porteurs de première polarité photo-générés dans la deuxième couche (2) pour être collectés par les premières électrodes (101).

6. Cellule photovoltaïque selon l'une des revendications précédentes, **caractérisée en ce que** l'interface entre les première et deuxième couches (1, 2) comporte une couche d'adaptation (40) d'accord de maille entre les premier et deuxième matériaux.

7. Cellule photovoltaïque selon l'une des revendications précédentes, dans laquelle l'un au moins des matériaux semi-conducteur est un empilement d'alliages semi-conducteur.

8. Cellule photovoltaïque selon l'une des revendications précédentes, dans laquelle la première couche de matériau absorbeur (1) est en Silicium (Si).

9. Cellule photovoltaïque selon l'une des revendications précédentes, dans laquelle la deuxième couche de matériau absorbeur (2) comprend un alliage de gallium indium phosphure (GaInP).

10. Cellule photovoltaïque selon la revendication 9 dans laquelle la couche intermédiaire (3) comprend l'un des alliages parmi le nitrure de gallium (GaN), l'oxyde de zinc (ZnO), l'oxyde de Nickel (NiO) ou l'oxyde de Manganèse (MnO).

11. Cellule photovoltaïque selon l'une des revendications 1 à 8, dans laquelle la deuxième couche de matériau absorbeur (2) est à base de chalcopyrites (CIGS) empilées avec des sulfures de cadmium (CdS) et/ou des sulfures et oxydes de Zinc (ZnOS).

12. Cellule photovoltaïque selon l'une des revendications 1 à 8, dans laquelle la deuxième couche de matériau absorbeur (2) est dans un matériau à base de kestérites (CZTS) empilées avec des sulfures de cadmium (CdS) et/ou des sulfures et oxydes de Zinc (ZnOS).

13. Cellule photovoltaïque selon l'une des revendications 11 ou 12, dans laquelle la couche intermédiaire (3) est une couche d'oxyde de zinc (ZnO).

14. Cellule photovoltaïque selon l'une quelconque des revendications 1 à 8 dans laquelle la deuxième couche de matériau absorbeur (2) est dans un matériau à base de pérovskites empilées sur du dioxyde titane (TiO2) et dans laquelle la couche intermédiaire (3) est du dioxyde d'étain dopé fluor (FTO).

15. Cellule photovoltaïque selon l'une des revendications 1 à 8, dans laquelle la deuxième couche de matériau absorbeur (2) est à base de silicium amorphe ou de silicium microcristallin hydrogéné, ou d'un alliage amorphe ou microcristallin de silicium, carbone et oxygène.

16. Cellule photovoltaïque selon l'une quelconque des revendications 1 à 15, dont une surface est dotée d'un revêtement anti-reflet.

## Patentansprüche

1. Mehrfachsolarzelle p-n mit gemeinsamer Kontaktelektrode, die mindestens eine erste Schicht (1) eines ersten Absorbermaterials aufweist, die eine Vorderfläche (11) sowie eine Rückfläche (12) umfasst, auf der erste Kontaktelektroden (101) eine erste Polarität aufweisen und kammartig mit zweiten Kontaktelektroden (102) mit einer zweiten Polarität, entgegengesetzt zur ersten Polarität, ineinandergreifen, **dadurch gekennzeichnet, dass** die Zelle außerdem aufweist:
eine zweite Schicht (2) eines zweiten Absorbermaterials über der Vorderfläche der ersten Schicht (1) und die eine Vorderfläche (21) und eine Rückfläche (22) aufweist, wobei dritte Kontaktelektroden (203) mit der zweiten Polarität auf der Vorderfläche (21) der zweiten Schicht (2) angeordnet sind,
und dass das erste und zweite Halbleitermaterial jeweilige Elektronenaffinitäten einerseits und jeweilige Bandlücken andererseits besitzen, die derart ausgewählt sind, dass:
- die erste Polarität aufweisende Träger in der Lage sind, durch eine Grenzfläche zwischen der ersten Schicht und der zweiten Schicht hindurchzutreten, und von den ersten Elektroden (101) aus der Gesamtheit der ersten und zweiten Schicht eingefangen werden, und
- die zweite Polarität aufweisende Träger von den zweiten Elektroden (102) aus der ersten Schicht (1) eingefangen werden,
- die zweite Polarität aufweisende Träger von den dritten Elektroden (203) aus der zweiten Schicht (2) eingefangen werden.

2. Solarzelle nach dem vorhergehenden Anspruch, bei der die die zweite Polarität aufweisenden Träger von dritten Elektroden (203) aus der zweiten Schicht (2) eingefangen werden ohne die Möglichkeit, die Grenzfläche zwischen der ersten und der zweiten Schicht zu überqueren.

3. Solarzelle nach einem der vorhergehenden Ansprüche, bei der das erste Absorbermaterial eine Dotierung gemäß der ersten Polarität aufweist.

4. Solarzelle nach einem der vorhergehenden Ansprüche, bei der die zweite Schicht (2) in ihrer Vorderfläche eine Kontaktschicht (4) aufweist, die dritte Elektroden (203) trägt und eine Dotierung gemäß der zweiten Polarität aufweist.

5. Solarzelle nach einem der vorhergehenden Ansprüche, bei der sie außerdem aufweist:
eine Zwischenschicht (3) zwischen der ersten Schicht (1) und der zweiten Schicht (2), die aus einem dritten Halbleitermaterial hergestellt ist, derart dass die Zwischenschicht (3) die in der zweiten Schicht (2) photoerzeugten Träger der zweiten Polarität blockiert, damit sie nur von den dritten Elektroden (203) eingefangen werden,
und die in der zweiten Schicht (2) photoerzeugten Träger der ersten Polarität durchlässt, damit sie von den ersten Elektroden (101) eingefangen werden.

6. Solarzelle nach einem der vorhergehenden Ansprüche, bei der die Grenzfläche zwischen der ersten und der zweiten Schicht (1, 2) eine Anpassungsschicht (40) zur Abstimmung der Gitterperiodizität zwischen dem ersten und zweiten Material aufweist.

7. Solarzelle nach einem der vorhergehenden Ansprüche, bei der mindestens eines der Halbleitermaterialien ein Halbleiterlegierungsstapel ist.

8. Solarzelle nach einem der vorhergehenden Ansprüche, bei der die erste Schicht (1) aus Absorbermaterial aus Silizium (Si) besteht.

9. Solarzelle nach einem der vorhergehenden Ansprüche, bei der die zweite Schicht (2) aus Absorbermaterial eine Galliumindiumphosphidlegierung (GaInP) ist.

10. Solarzelle nach Anspruch 9, bei der die Zwischenschicht (3) eine Legierung aus den Legierungen Galliumnitrid (GaN), Zinkoxid (ZnO), Nickeloxid (NiO) oder Manganoxid (MnO) enthält.

11. Solarzelle nach einem der Ansprüche 1 bis 8, bei der die zweite Schicht (2) aus Absorbermaterial auf Basis von Chalkopyriten (CIGS), gestapelt mit Cadmiumsulfiden (CdS) und/oder Zinksulfiden und -oxiden (ZnOS) ausgebildet ist.

12. Solarzelle nach einem der Ansprüche 1 bis 8, bei der die zweite Schicht (2) aus Absorbermaterial auf Basis von Kesteriten gestapelt mit Cadmiumsulfiden (CdS) und/oder Zinksulfiden und -oxiden ausgebildet ist.

13. Solarzelle nach einem der Ansprüche 11 oder 12, bei der die Zwischenschicht (3) eine Zinkoxidschicht (ZnO) ist.

14. Solarzelle nach einem der Ansprüche 1 bis 8, bei der die zweite Schicht (2) aus Absorbermaterial aus einem Material auf Basis von Perowskiten, gestapelt auf Titandioxiden (TiO2) besteht und dass die Zwischenschicht (3) aus einem mit Fluor dotierten Zinndioxid (FTO) besteht.

15. Solarzelle nach einem der Ansprüche 1 bis 8, bei der die zweite Schicht (2) aus Absorbermaterial auf Basis von amorphem Silizium oder hydriertem mikrokristallinen Silizium oder einer amorphen oder mikrokristallinen Legierung aus Silizium, Kohlenstoff und Sauerstoff ausgebildet ist.

16. Solarzelle nach einem beliebigen der Ansprüche 1 bis 15, bei der eine Fläche mit einer antireflektierenden Beschichtung ausgebildet ist.

## Claims

1. A p-n multi-junction photovoltaic cell with a common contact electrode comprising at least a first layer of a first absorber material (1) comprising a front face (11) as well as a rear face (12) on which first contact electrodes (101) have a first polarity and are interdigitated with second contact electrodes (102) having a second polarity, opposite to the first polarity,
**characterized in that** the cell further comprises:
a second layer of a second absorber material (2), above the front face of the first layer (1), and comprising a front face (21) and a rear face (22), wherein third contact electrodes (203) having the second polarity, are placed on the front face (21) of the second layer (2),
and **in that** the first and second semiconductor materials, have respective electronic affinities, on the one hand, and respective bandgap widths, on the other hand, chosen so that:
- carriers with the first polarity are able to transit between the first and second layer via an interface, and are collected from the set of first and second layers by the first electrodes (101), and
- carriers with the second polarity are collected from the first layer (1) by the second electrodes (102),
- carriers with the second polarity are collected from the second layer (2) by the third electrodes (203).

2. Photovoltaic cell according to the preceding claim, **characterized in that** carriers having the second polarity are collected from the second layer (2) by the third electrodes (203), without the possibility of crossing said interface between the first and the second layer.

3. Photovoltaic cell according to one of the preceding claims, **characterized in that** the first absorber material is doped according to the first polarity.

4. Photovoltaic cell according to one of the preceding claims, **characterized in that** the second layer (2) comprises in its front face a contact layer (4) carrying the third electrodes (203) and being doped according to the second polarity.

5. Photovoltaic cell according to one of the preceding claims, **characterized in that** it further comprises an intermediate layer (3) between the first layer (1) and the second layer (2), made of a third semiconductor material so that the intermediate layer (3) blocks the second polarity carriers photo-generated in the second layer (2) in order to be collected only by the third electrodes (203),
and let the carriers of first polarity photo-generated in the second layer (2) pass to be collected by the first electrodes (101).

6. Photovoltaic cell according to one of the preceding claims, **characterized in that** the interface between the first and second layers (1, 2) has a lattice constant adaptation layer (40) between the first and second materials.

7. Photovoltaic cell according to one of the preceding claims, wherein at least one of the semiconductor materials is a stack of semiconductor alloys.

8. Photovoltaic cell according to one of the preceding claims, wherein the first layer of absorber material (1) is in silicon (Si).

9. Photovoltaic cell according to one of the preceding claims, wherein the second layer of absorber material (2) comprises a gallium indium phosphide alloy (GaInP).

10. Photovoltaic cell according to claim 9 wherein the intermediate layer (3) comprises one of the alloys among gallium nitride (GaN), zinc oxide (ZnO), nickel oxide (NiO) or manganese oxide (MnO).

11. Photovoltaic cell according to one of the claims 1 to 8, wherein the second layer of absorber material (2) is based on chalcopyrites (CIGS) stacked with cadmium sulphides (CdS) and/or zinc oxides and sulphides (ZnOS).

12. Photovoltaic cell according to one of the claims 1 to 8, wherein the second layer of absorber material (2) is in a kesterite material (CZTS) stacked with cadmium sulphides (CdS) and/or zinc oxides and sulphides (ZnOS).

13. Photovoltaic cell according to one of the claims 11 or 12, wherein the intermediate layer (3) is a layer of zinc oxide (ZnO).

14. Photovoltaic cell according to any one of the claims 1 to 8, wherein the second layer of absorber material (2) is in a material based on perovskites stacked on titanium dioxide (TiO2) and wherein the intermediate layer (3) is fluorine-doped tin dioxide (FTO).

15. Photovoltaic cell according to one of the claims 1 to 8, wherein the second layer of absorber material (2) is based on amorphous silicon or hydrogenated microcrystalline silicon, or an amorphous or microcrystalline silicon, carbon and oxygen.

16. Photovoltaic cell according to any one of the claims 1 to 15, wherein a surface is provided with an anti-reflective coating.
